# EUROPEAN PATENT APPLICATION

(11) **EP 4 513 754 A1**
(43) Date of publication of application: **26.02.2025**
(21) Application number: 24194622.7
(22) Date of filing: 14.08.2024
(51) Int. Cl.: H03F 3/08, H03F 3/45, H03G 3/30, G01J 1/46

(54) **APPARATUS AND METHODS FOR INPUT RECOVERY OF LOGARITHMIC TRANSIMPEDANCE AMPLIFIERS**

(30) Priority: 24.08.2023 US 202363578587 P; 06.08.2024 US 202418795856
(71) Applicant: Analog Devices, Inc., Wilmington, MA 01887 (US)
(72) Inventor: Stroet, Petrus M., Wilmington, 01887 (US)
(74) Representative: Horler, Philip John

(57) **Abstract**

Apparatus and methods for preventing overshoot for a high-to-low input current transient of a logarithmic transimpedance amplifier are disclosed. In certain embodiments, an amplifier system includes a logarithmic transimpedance amplifier having an input that receives an input current signal, and a current pulse injection circuit that injects a current pulse into the input of the logarithmic transimpedance amplifier in response to detecting a transition of the input current signal from a high current value to a low current value.

## Description

### Field of the Disclosure

Embodiments of the invention relate to electronic systems, and more particularly to, electronic circuits for logarithmic conversion.

### BACKGROUND

Logarithmic converters provide an output signal that changes in relation to a logarithm of an applied input signal.

One type of logarithmic detector is a trans-linear logarithmic detector that uses the trans-linear properties of a bipolar transistor to provide logarithmic conversion. In one example, a collector and a base of an NPN bipolar transistor are directly connected to a gate and a source, respectively, of an n-type metal-oxide-semiconductor (NMOS) transistor. Additionally, an input current is applied to the collector of NPN bipolar transistor and the base of the NPN bipolar transistor generates a log voltage.

In another example of a trans-linear logarithmic detector, a collector and an emitter of an NPN bipolar transistor are directly connected to an inverting input and an output, respectively, of an operational amplifier (op-amp). Additionally, a base of the NPN bipolar transistor and a non-inverting input of the op-amp are grounded, while an input current is applied to the collector of NPN bipolar transistor such that the emitter of the NPN bipolar transistor generates a log voltage. By using the op-amp, the collector-to-base voltage of the NPN bipolar transistor can be controlled close to zero.

In certain applications, a second copy of a logarithmic detector is included and driven by a reference current, with a difference between the pair of logarithmic detectors taken to cancel the saturation current of the NPN bipolar transistor.

### SUMMARY OF THE DISCLOSURE

Apparatus and methods for preventing overshoot for a high-to-low input current transient of a logarithmic transimpedance amplifier are disclosed. In certain embodiments, an amplifier system includes a logarithmic transimpedance amplifier having an input that receives an input current signal, and a current pulse injection circuit that injects a current pulse into the input of the logarithmic transimpedance amplifier in response to detecting a transition of the input current signal from a high current value to a low current value. By preventing overshoot in this manner, slow recovery for a logarithmic transimpedance amplifier is avoided.

In one aspect, an amplifier system includes a logarithmic transimpedance amplifier having an input configured to receive an input current signal, and a current pulse injection circuit configured to inject a current pulse into the input of the logarithmic transimpedance amplifier in response to detecting a transition of the input current signal from a high current value to a low current value.

In another aspect, a method of compensating for amplifier input recovery time is provided. The method includes receiving an input current signal at an input of a logarithmic transimpedance amplifier, detecting a transition of the input current signal from a high current value to a low current value using a current pulse injection circuit, and injecting a current pulse into the input of the logarithmic transimpedance amplifier in response to detecting the transition of the input current signal using the current pulse injection circuit.

In another aspect, a photocurrent detection system includes a photodiode configured to generate an input current signal, and a semiconductor die. The semiconductor die includes a logarithmic transimpedance amplifier having an input configured to receive the input current signal. The semiconductor die further includes a current pulse injection circuit configured to inject a current pulse into the input of the logarithmic transimpedance amplifier in response to detecting a transition of the input current signal from a high current value to a low current value.

### BRIEF DESCRIPTION OF THE DRAWINGS

Figure 1A is a schematic diagram of one embodiment of a logarithmic current-to-voltage converter that can provide logarithmic conversion in a logarithmic transimpedance amplifier.
Figure 1B is a schematic diagram of one embodiment of a logarithmic current-to-voltage conversion system that can provide logarithmic conversion in a logarithmic transimpedance amplifier.
Figure 2 is a graph of one example of output voltage versus time for an output of a logarithmic transimpedance amplifier in response to a high-to-low input current transition.
Figure 3A is a schematic diagram of a logarithmic transimpedance amplifier with active photodiode biasing according to one embodiment.
Figure 3B is a graph of one embodiment of photodiode bias voltage versus photodiode current for the active photodiode biasing of Figure 3A.
Figure 4 is a schematic diagram of a logarithmic transimpedance amplifier with input current pulse injection according to one embodiment.
Figure 5A is a graph of one example of transient simulations for the logarithmic transimpedance amplifier of Figure 4 for various decay settings for input current pulse injection.
Figure 5B is a graph of one example of transient simulations for the pulse stretcher circuit of Figure 4 for various amplitude settings for input current pulse injection.
Figure 6 is a graph of one example of input voltage versus input current for a logarithmic transimpedance amplifier.
Figure 7 is a schematic diagram of a logarithmic transimpedance amplifier with active photodiode biasing according to another embodiment.
Figure 8 is a schematic diagram of a logarithmic transimpedance amplifier with input current pulse injection according to another embodiment.

### DETAILED DESCRIPTION

The following detailed description of embodiments presents various descriptions of specific embodiments of the invention. However, the invention can be embodied in a multitude of different ways. In this description, reference is made to drawings. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

During a high-to-low input current transient applied to a logarithmic transimpedance amplifier, the output can be clipped to a low state for an extended period of time.

For example, output clipping of a logarithmic transimpedance amplifier can be caused by an active photodiode bias (PDB) circuit that increases the photodiode's reverse voltage for high input optical power to prevent the photodiode's series resistance from saturating the photodiode. Additionally, a delay in the PDB in response to a high-to-low input current transient can lead to a negative current via the photodiode's parallel capacitance. The negative current can flow from the logarithmic transimpedance amplifier's input causing the input node to discharge substantially.

Apparatus and methods for preventing overshoot for a high-to-low input current transient of a logarithmic transimpedance amplifier are disclosed. In certain embodiments, an amplifier system includes a logarithmic transimpedance amplifier having an input that receives an input current signal, and a current pulse injection circuit that injects a current pulse into the input of the logarithmic transimpedance amplifier in response to detecting a transition of the input current signal from a high current value to a low current value.

Accordingly, the current pulse charges up an input node capacitance of the amplifier quickly to prevent output clipping. The current pulse injection circuit can be implemented with programmable current pulse intensity and/or decay time to aid in providing a suitable input current pulse.

By preventing overshoot in response to a high-to-low input current transient, slow recovery for a logarithmic transimpedance amplifier is avoided.

In certain implementations, the amplitude and/or duration of the input current pulse is set by a control signal that is received over an interface of a semiconductor die and/or that is stored in a non-volatile memory (NVM).

To detect the high-to-low input current transition, any suitable detection scheme can be used. In certain implementations, the logarithmic transimpedance amplifier generates a copy of the input current signal that is provided as an input to the current pulse injection circuit. For example, the input stage of the logarithmic transimpedance amplifier can include a current mirror that generates the copy as a down-scaled replica of the input current signal. The current pulse injection circuit can use various circuitry, such as a DC amplifier, a limiter, a comparator, a filter (for instance, a resistor-capacitor or R-C filter) and/or other suitable circuit(s) to generate a pulse, which can be provided to a capacitor (for instance, a controllable capacitor) and/or other suitable circuit(s) to generate a current pulse that can be provided to the amplifier's input.

The current pulse injected by the input current pulse injection circuit can be shaped as desired for a particular application. In some implementations, a shape of the current pulse exponentially decays versus time.

Such amplifier systems are well-suited for a variety of applications including, for example, optical applications in which a photodiode generates the input current signal in response to light from an optical fiber.

In certain implementations, an active photodiode bias circuit is further included for biasing a cathode of the photodiode with a bias voltage that is based on a current of the photodiode minus a threshold current value. Such a threshold current value can be set by a control signal, such as a control signal received over an interface of a semiconductor die and/or from an NVM. In some implementations, the threshold current value sets a dead zone for active biasing.

Accordingly, overshoot compensation can be combined with active photodiode biasing.

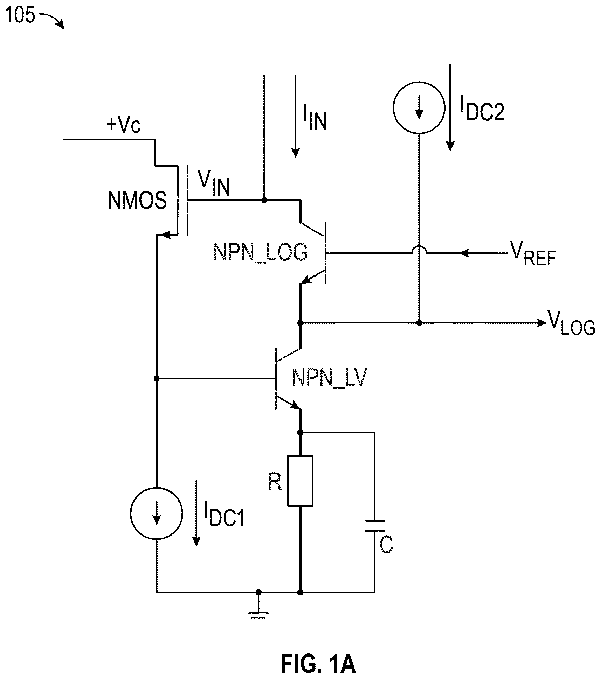

Figure 1A is a schematic diagram of one embodiment of a logarithmic current-to-voltage converter 105 that can provide logarithmic conversion in a logarithmic transimpedance amplifier. For example, the logarithmic current-to-voltage converter 105 depicts one example of a logarithmic conversion circuit that can be included as part of a logarithmic transimpedance amplifier, for instance, to serve as an input stage of the logarithmic transimpedance amplifier. Certain logarithmic transimpedance amplifiers can include further circuitry, including, but not limited to, an output stage for buffering and/or otherwise processing the logarithmic output voltage.

In the illustrated embodiment, the logarithmic current-to-voltage converter 105 includes a field-effect transistor (FET) transistor (NMOS, in this example), a first bipolar transistor NPN_LOG (n-type, in this example), a second bipolar transistor NPN_LV (n-type, in this example), a first DC current source I_{DC1}, a second DC current source I_{DC2}, a capacitor C, and a resistor R.

The logarithmic current-to-voltage converter 105 depicts one example of circuitry for a logarithmic transimpedance amplifier. Although one embodiment for logarithmic current-to-voltage conversion is shown, a logarithmic transimpedance amplifier can include other types of logarithmic current-to-voltage converters.

In the illustrated embodiment, the NMOS transistor includes a drain that receives a power supply voltage +Vc, and a gate connected to a collector of the first bipolar transistor NPN_LOG and to an input terminal. The input terminal receives an input current I_{IN} and has an input voltage V_{IN}. The NMOS transistor further includes a source connected to a base of the second bipolar transistor NPN_LV and to the first DC current source I_{DC1}. Additionally, a base of the first bipolar transistor NPN_LOG receives a reference voltage V_{REF} and an emitter of the first bipolar transistor NPN_LOG is connected to an output terminal that provides a logarithmic voltage V_{LOG}. The emitter of the first bipolar transistor NPN_LOG is also connected to the second DC current source I_{DC2} and to a collector of the second bipolar transistor NPN_LV. The resistor R is connected between an emitter of the second bipolar transistor NPN_LV and ground, and the capacitor C is connected in parallel with the resistor R.

As shown in Figure 1A, the input current I_{IN} received from the input terminal is provided to the collector of the first bipolar transistor NPN_LOG. Additionally, the logarithmic current-to-voltage converter 105 converts the input current I_{IN} into the logarithmic voltage V_{LOG}, which is provided at the output terminal.

In the illustrated embodiment, the capacitor C operates to extend the bandwidth of the collector current over base voltage while the resistor R reduces the loop gain at high levels of the input current I_{IN}. In certain implementations, the capacitor C and/or the resistor R are controllable (for example, by using a capacitor array that is programmable to control a capacitance value and/or a resistor array that is programmable to control a resistance value).

The logarithmic current-to-voltage converter 105 can achieve a higher speed relative to a configuration using an op-amp to provide feedback. For example, when an op-amp is included in the feedback loop, the additional components introduce extra phase shift that moves the second-order pole downwards in frequency. Although high value compensation capacitors can be added to keep such a feedback loop stable, high capacitance slows the circuit down.

Furthermore, the logarithmic current-to-voltage converter 105 has superior noise performance at low levels of the input current I_{IN} relative to an implementation with an op-amp in the feedback loop. For example, when an op-amp provides feedback at low input current levels, the bandwidth of the circuit reduces considerably, resulting in the loop gain to drop below 0dB at a frequency below the baseband bandwidth of the rest of the circuit. This results in the loop not cancelling the bias noise sources in a significant manner. In that case, any noise voltage present on the reference voltage will be amplified significantly by the op-amp.

In contrast, any noise on the reference voltage V_{REF} in Figure 1A will be amplified much less since the amplification at the base of the first bipolar transistor NPN_LOG (which is connected as a common-base stage) is much lower.

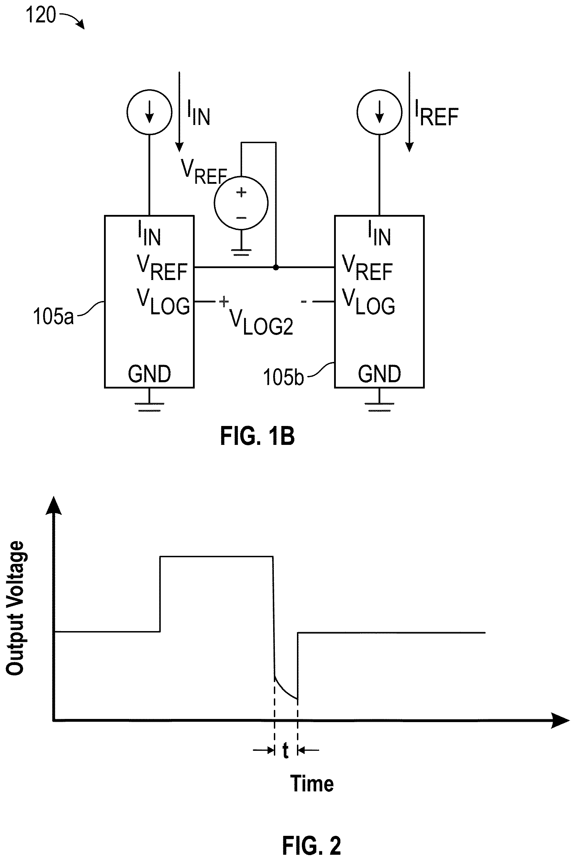

Figure 1B is a schematic diagram of one embodiment of a logarithmic current-to-voltage conversion system 120 that can provide logarithmic conversion in a logarithmic transimpedance amplifier. For example, the logarithmic current-to-voltage system 120 depicts one example of circuitry that can be included as part of a logarithmic transimpedance amplifier, for instance, to serve as an input stage of the logarithmic transimpedance amplifier to generate a logarithmic voltage that can be buffered and/or further processed as desired. Although one example embodiment is shown, logarithmic transimpedance amplifiers can be implemented in other ways.

The logarithmic current-to-voltage conversion system 120 includes a first logarithmic current-to-voltage converter 105a, a second logarithmic current-to-voltage converter 105b, a reference current source I_{REF}, and a reference voltage source V_{REF}. The logarithmic current-to-voltage conversion system 120 is also depicted with an input current source I_{IN}, which represents a photodiode or other input current source to the system 120.

As shown in Figure 1B, multiple instantiations or replicas of the logarithmic current-to-voltage converter 105 of Figure 1A have been arranged to provide logarithmic current to voltage conversion with enhanced performance. In particular, the first logarithmic current-to-voltage converter 105a serves as an input channel while the second logarithmic current-to-voltage converter 105b serves as a reference channel.

As shown in Figure 1B, the log voltage V_{LOG2} is taken differentially between the V_{LOG} outputs of the first logarithmic current-to-voltage converter 105a and the second logarithmic current-to-voltage converter 105b. By using a differential voltage between the input channel and the reference channel, the saturation current of the bipolar transistors (NPN_LOG transistors within converters 105a and 105b) is canceled.

Figure 2 is a graph of one example of output voltage versus time for an output of a logarithmic transimpedance amplifier in response to a high-to-low input current transition. In Figure 2, the logarithmic transimpedance amplifier's output voltage drops over a time t due to a discharge of the input node voltage of the logarithmic transimpedance amplifier.

As shown in Figure 2, a slow recovery is observed for a logarithmic transimpedance amplifier's output after a high-to-low transition in input current (from a first or high input current level I_{H} to a second or low input current level I_{L}).

The slow recovery can arise from a number of sources. In a first example, the high-to-low transition leads to an overload event that breaks a feedback loop of the transimpedance amplifier. In a second example, a delay in an active photodiode bias (PDB) driver can cause the cathode voltage of a photo diode to fall while the input current is already at I_{L}. This can lead to a photodiode parallel capacitance pulling current out of the input.

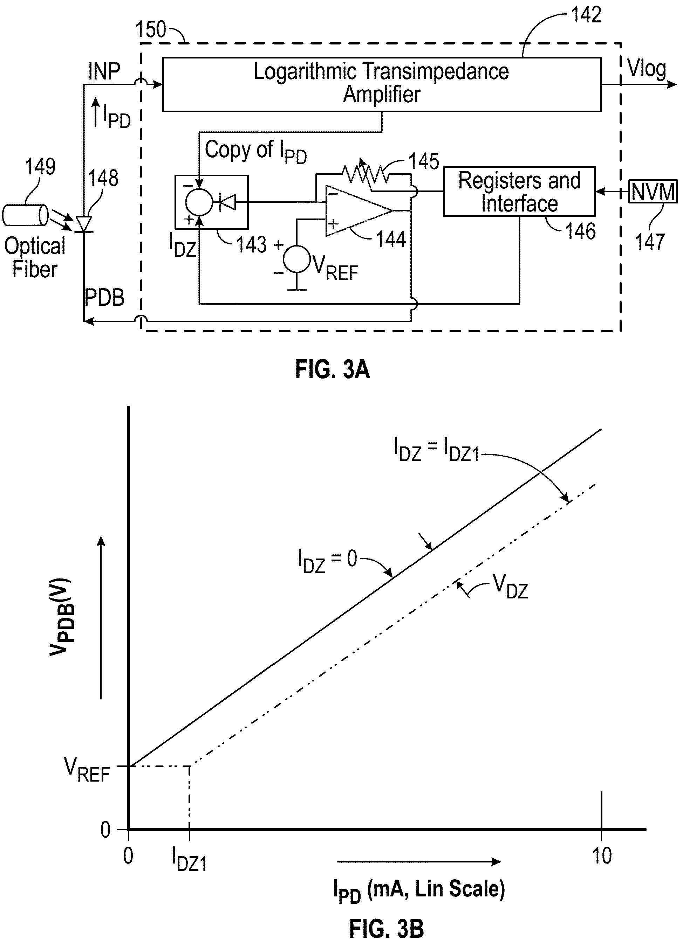

Figure 3A is a schematic diagram of a logarithmic transimpedance amplifier with active photodiode biasing according to one embodiment. In the illustrated embodiment, an integrated circuit (IC) or semiconductor die 150 includes a logarithmic transimpedance amplifier 142, a differencing circuit with dead zone 143, an amplifier 144, a controllable feedback resistor 145, registers and interface 146, and a reference voltage source V_{REF}. As shown in Figure 3A, the IC 150 receives an input current I_{PD} from a photodiode 148 that responds to light received from an optical fiber 149. The differencing circuit with dead zone 143, the amplifier 144, the controllable feedback resistor 145, and the reference voltage source V_{REF} collectively operate as an active photodiode bias circuit for the photodiode 148.

The embodiment of Figure 3A depicts one example of active photodiode biasing for a logarithmic transimpedance amplifier. Such active photo biasing can be used in conjunction with any of the input current pulse injection schemes herein. However, the teachings herein are applicable to other implementations of active biasing as well as to implementations of input current pulse injection that do not use any active photo biasing. Accordingly, other implementations are possible.

As shown in Figure 3A, the photodiode 148 provides the input current I_{PD} to a current input INP of the IC 150. The input current I_{PD} is provided to an input of the logarithmic transimpedance amplifier 142. Additionally, the logarithmic transimpedance amplifier 142 generates a copy of the input current I_{PD} that is provided to the differencing circuit with dead zone 143. The copy of the input current I_{PD} can be generated in any suitable manner including, but not limited to, using a current mirror of an input stage of the logarithmic transimpedance amplifier 142 to generate the copy as a down-scaled replica of the input current I_{PD}.

With continuing reference to Figure 3A, the logarithmic transimpedance amplifier 142 amplifies the input current I_{PD} to generate a logarithmic output voltage Vlog. Additionally, the differencing circuit with dead zone 143 determines a difference between a dead zone current I_{DZ} and the copy of the input current I_{PD}. When the input current is less than or equal to the dead zone current I_{DZ}, the input current falls within the dead zone and thus the differencing circuit's output can provide a zero or other signal level indicating operation in the dead zone. However, when the input current is greater than the dead zone current I_{DZ}, the differencing circuit's output changes (for instance, monotonically increases) based on a difference between the input current and the dead zone current I_{DZ}.

In certain implementations, the output of the differencing circuit with dead zone 143 corresponds to an output voltage that is provided to an inverted input of the amplifier 144.

With continuing reference to Figure 3A, the amplifier 144 generates an output signal that is based on a difference between the reference voltage (for instance, 1.5V) from the reference voltage source V_{REF} and the output of the differencing circuit with dead zone 143. The output signal of the amplifier 144 serves as an active PDB signal that biases the cathode of the photodiode 148.

As shown in Figure 3A, a controllable feedback resistor 145 is connected between the output and inverting input of the amplifier 144. A value of the controllable feedback resistor 145 and a value of the dead zone current I_{DZ} are configurable by data that is received over an interface of the IC 150 and that is stored in registers. For example, the registers and interface 146 can receive configuration data (for instance, from a non-volatile memory or NVM 147) that controls the feedback resistance and/or dead zone current level. By implementing the IC 150 in this manner, configurability for active photodiode biasing and the dead zone is provided.

For example, for larger current levels of the input current I_{PD}, the photodiode's cathode voltage increases (by active PDB) to avoid photodiode saturation due to series resistance. The amount of increase can be controlled via the registers and interface 145 (for instance, I²C). Active PDB helps to reduce the photodiode's dark current for low I_{PD} by reducing a voltage difference between the photodiode's cathode voltage (V_{PDB}) and the photodiode's anode voltage (V_{INP}). Moreover, the dead zone current I_{DZ} can be controlled by the registers and interface 145.

Figure 3B is a graph of one embodiment of photodiode bias voltage versus photodiode current for the active photodiode biasing of Figure 3A. As shown in Figure 3B, for I_{PD} < I_{DZ} the active PDB (V_{PDB}) corresponds to the reference voltage (V_{REF}). However, as the input current level increases above the dead zone current I_{DZ}, V_{PDB} increases based on a difference between I_{PD} and I_{DZ}.

One benefit of using a dead zone is that for a high-to-low input current transition, the PDB circuit has some time to settle the PDB voltage between the time point of the input current being below I_{DZ1} and the time point when the input current is I_{L}. For input current transitions below I_{DZ1}, the PDB voltage is a constant voltage V_{REF} to prevent the PDB circuit from generating a negative current into the input.

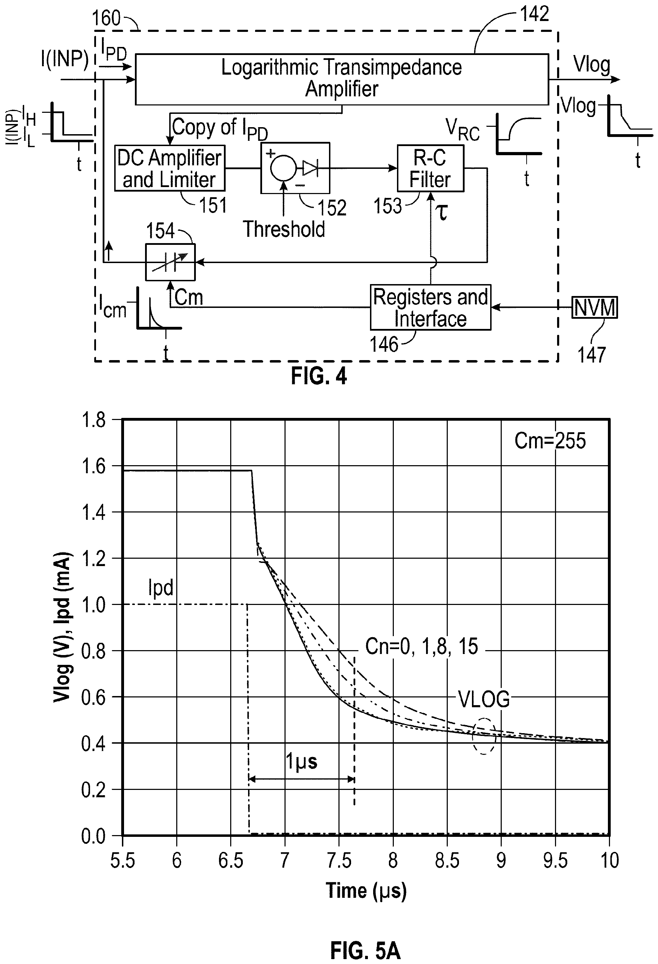

Figure 4 is a schematic diagram of a logarithmic transimpedance amplifier with input current pulse injection according to one embodiment. In the illustrated embodiment, an IC 160 includes a logarithmic transimpedance amplifier 142, a DC amplifier and limiter 151, a differencing circuit with threshold 152, a controllable resistor-capacitor (R-C) filter 153, a controllable capacitor 154, and registers and interface 146. The IC 160 can receive an input current from a photodiode that responds to light received from an optical fiber. The DC amplifier and limiter 151, the differencing circuit with threshold 152, the controllable R-C filter 153, and the controllable capacitor 154 collectively operate as one embodiment of a current pulse injection circuit that injects an input current pulse in response to a high-to-low input current transient to prevent overshoot of a logarithmic transimpedance amplifier.

Although Figure 4 depicts one embodiment of input current pulse injection for a logarithmic transimpedance amplifier, the teachings herein are applicable to other implementations of input current pulse injection. Accordingly, other implementations are possible. Furthermore, the input current pulse injection schemes herein can be combined with photodiode active biasing, such as the photodiode active biasing scheme of Figure 3A.

In the illustrated embodiment, the input current is depicted as transitioning from a high current level I_{H} to a low current level I_{L} in this example to represent a high-to-low input current transition.

As shown in Figure 4, the input current I_{PD} is provided to an input of the logarithmic transimpedance amplifier 142, which generates a copy of the input current I_{PD} that is provided to the DC amplifier and limiter 151.

The DC amplifier and limiter 151 receives the copy of the input current I_{PD} and outputs an amplified current that is provided to the differencing circuit with threshold 152. The differencing circuit with threshold 152 compares the amplified input current to a threshold. Below the threshold, the output of the differencing circuit with threshold 152 is inactive. However, when the amplified input current is greater than the threshold, the differencing circuit with threshold 152 outputs an output signal that is provided to the controllable R-C filter 153.

In certain implementations, the threshold is selected to be at a middle or medium input current level. In configurations in which active PDB is also used, the threshold can be selected to be less than the dead zone current I_{DZ} to prevent the PDB from being active while the pulse stretch for input current pulse injection is not.

In response to a high-to-low input current transition, the DC amplifier and limiter 151 and the differencing circuit with threshold 152 operate in combination to generate an output signal corresponding to a step function, in this example. The DC amplifier and limiter 151 and the differencing circuit with threshold 152 depict one example of circuitry suitable for detecting a high-to-low input current transition. However, other implementations of detecting high-to-low input current transitions are possible.

With continuing reference to Figure 4, the output of the differencing circuit with threshold 152 is filtered by the controllable R-C filter 153 to generate a filtered output signal that is provided to the controllable capacitor 154. Additionally, the controllable capacitor 154 is connected between the output of the controllable R-C filter 153 and the input of the logarithmic transimpedance amplifier 142 and serves to inject an input current pulse in response to the filtered output signal.

Thus, the input current pulse injection scheme of Figure 4 serves to inject an input current pulse in response to detection of a high-to-low input current transition. The input current pulse can correspond to an exponentially decaying current pulse, in some examples.

The current pulse injected into the input is controllable by configuration data received from the registers and interface 146. For example, the amplitude of the pulse can be set by a capacitance value Cm of the controllable capacitor 154 and by a decay time of the pulse can be set by a time constant τ of the controllable R-C filter 153. Such configuration data can be received in some implementations from an NVM 147.

Figure 5A is a graph of one example of transient simulations for the logarithmic transimpedance amplifier of Figure 4 for various decay settings for input current pulse injection. The transient simulations depict one example of output voltage Vlog of the transimpedance amplifier 142 for various decay time settings set by controlling the time constant τ of the controllable R-C filter 153. The transient simulations are depicted for an example simulation in which the photodiode input current I_{PD} is transitioning from 1mA to 10nA.

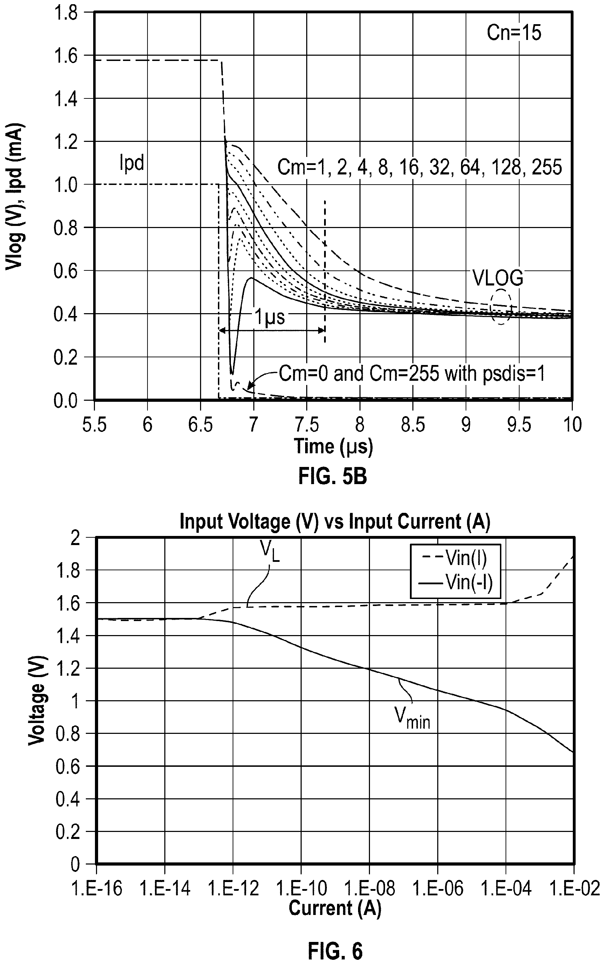

Figure 5B is a graph of one example of transient simulations for the pulse stretcher circuit of Figure 4 for various amplitude settings for input current pulse injection. The transient simulations depict one example of output voltage VLOG of the transimpedance amplifier 142 for various amplitude settings set by controlling the capacitance value Cm of the controllable capacitor 154. The transient simulations are depicted for an example simulation in which the photodiode input current I_{PD} is transitioning from 1mA to 1nA.

Figure 6 is a graph of one example of input voltage versus input current for a logarithmic transimpedance amplifier.

A logarithmic transimpedance amplifier cannot process negative input currents properly because the logarithmic value of a negative number is mathematically non-existent. Absent compensation, an input transient current from high-to-low with overshoot can result in a temporary negative input current that is highly undesirable.

For example, in Figure 6, V_{L} corresponds to the equilibrium voltage at the input node of the logarithmic transimpedance amplifier for the low input level current I_{L}, while V_{MIN} corresponds to the input node voltage for a negative input current. Thus, for low I_{L}, the recovery time of a logarithmic transimpedance amplifier can be quite long. Additionally, V_{MIN} can be determined by how much negative input current is sourced during the transition.

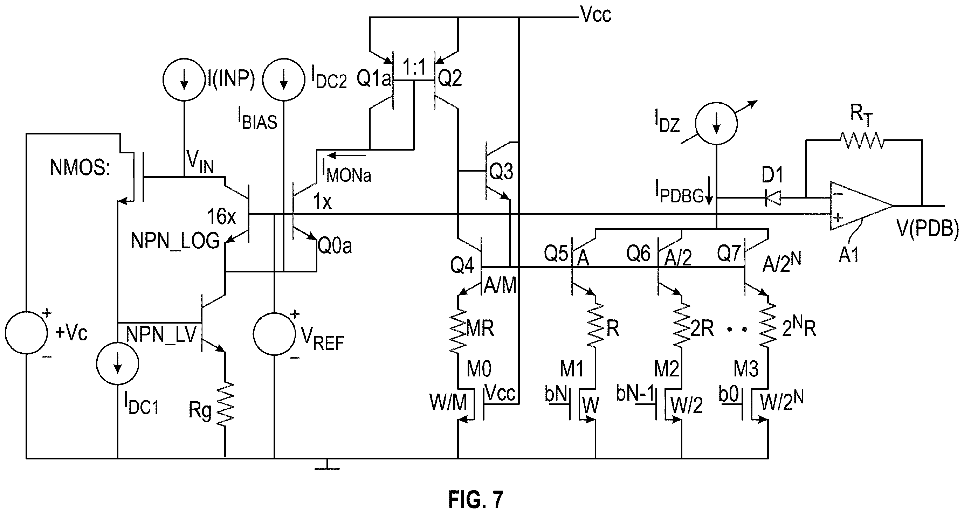

Figure 7 is a schematic diagram of a logarithmic transimpedance amplifier with active photodiode biasing according to another embodiment.

In Figure 7, the logarithmic transimpedance amplifier including a logarithmic current-to-voltage converter similar to the logarithmic current-to-voltage converter 105 of Figure 1A. For example, the logarithmic current-to-voltage converter includes an NMOS transistor, a first bipolar transistor NPN_LOG, a second bipolar transistor NPN_LV, a first DC current source I_{DC1}, a second DC current source I_{DC2}, and a resistor Rg in a configuration similar to that of Figure 1A.

As shown in Figure 7, a bipolar transistor Q0a includes a base and an emitter connected to the base and emitter, respectively, of the bipolar transistor NPN_LOG. The bipolar transistor Q0a is smaller (by a factor of 16, in this example), and generates a current I_{MONa} that corresponds to a copy of the input current. The copy of the input current is provided to a differencing circuit with dead zone that is implemented using bipolar transistors Q1a, Q2, Q3, Q4, Q5, Q6 ... Q7, FET transistors M0, M1, M2 ... M3, resistors MR, R, 2R ... 2^{N}R, diode D1, and variable current source I_{DZ}. In the illustrated embodiment, the dead zone is controlled by a current of the variable current source I_{DZ}.

As shown in Figure 7, bits bN, bN-1, ... b0 (N+1 bits in total) are used to turn on or off the transistors M1, M2, ... M3, respectively, to change an amount of sunk current to thereby control the trans-resistance of the active photodiode biasing circuit (thus serving as an alternative of changing the feedback resistor R_{T}). Additionally, the output of the differencing circuit with dead zone is provided to an amplifier A1 with feedback resistor R_{T}, which are implemented to generate an active photodiode biasing signal in a manner similar to that of Figure 3A.

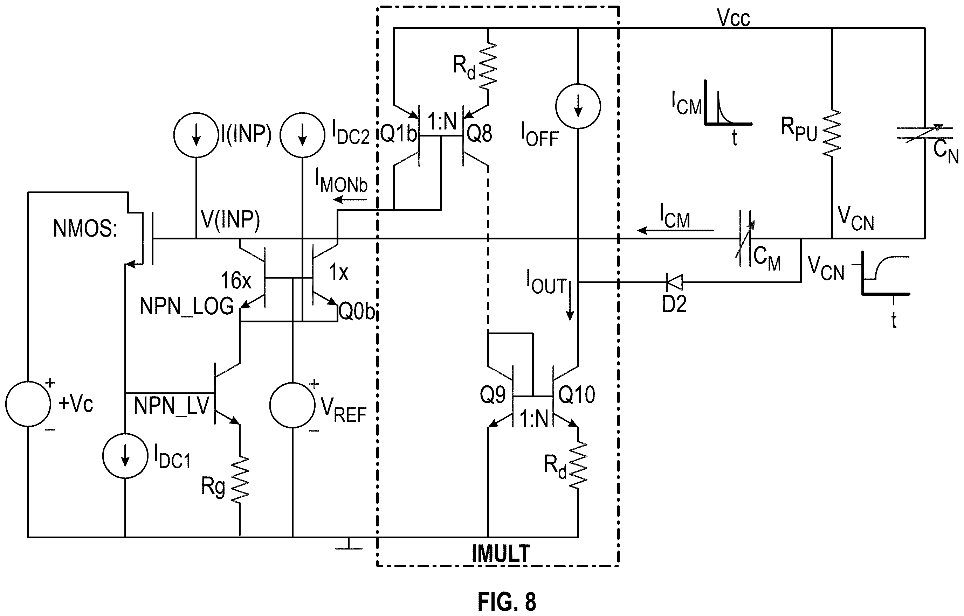

Figure 8 is a schematic diagram of a logarithmic transimpedance amplifier with input current pulse injection according to another embodiment.

In Figure 8, the logarithmic transimpedance amplifier including a logarithmic current-to-voltage converter similar to the logarithmic current-to-voltage converter 105 of Figure 1A. For example, the logarithmic current-to-voltage converter includes an NMOS transistor, a first bipolar transistor NPN_LOG, a second bipolar transistor NPN_LV, a first DC current source I_{DC1}, a second DC current source I_{DC2}, and a resistor Rg in a configuration similar to that of Figure 1A.

As shown in Figure 8, a bipolar transistor Q0b includes a base and an emitter connected to the base and emitter, respectively, of the bipolar transistor NPN_LOG. The bipolar transistor Q0b is smaller (by a factor of 16, in this example), and generates a current I_{MONb} that corresponds to a copy of the input current. The copy of the input current is amplified and thereafter to provided to a differencing circuit with threshold, which are collective implemented using bipolar transistors Q1b, Q8, Q9, and Q10, diode D2, current source I_{OFF}, and resistors R_{d}. In Figure 8, the dashing between the collector of the bipolar transistor Q8 and the node connected to the collector of the bipolar transistor Q9 indicates that multiple stages can be used to provide current amplification as desired.

With continuing reference to Figure 8, the output of the differencing circuit with threshold is provided to a controllable R-C filter implemented using resistor R_{PU} and controllable capacitor C_{N}. The output of the controllable R-C filter is provided to a controllable capacitor C_{M} to generate a current I_{CM} that is injected into the input of the logarithmic transimpedance amplifier.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

## Claims

1. An amplifier system comprising:
a logarithmic transimpedance amplifier having an input configured to receive an input current signal; and
a current pulse injection circuit configured to inject a current pulse into the input of the logarithmic transimpedance amplifier in response to detecting a transition of the input current signal from a high current value to a low current value.

2. The amplifier system of Claim 1, wherein at least one of an amplitude or a duration of the current pulse is set by a control signal.

3. The amplifier system of Claim 2, further comprising a non-volatile memory (NVM) configured to generate the control signal.

4. The amplifier system of any preceding Claim, wherein a shape of the current pulse exponentially decays versus time.

5. The amplifier system of any preceding Claim, further comprising a photodiode configured to generate the input current signal.

6. The amplifier system of Claim 5, further comprising an active photodiode bias circuit configured to bias a cathode of the photodiode with a bias voltage that is based on a current of the photodiode minus a threshold current value,
wherein, optionally, the threshold current value is set by a control signal.

7. The amplifier system of Claim 6, further comprising a non-volatile memory (NVM) configured to generate the control signal.

8. The amplifier system of any preceding Claim, wherein the logarithmic transimpedance amplifier is configured to generate a copy of the input current that is provided to an input of the current pulse injection circuit.

9. A method of compensating for amplifier input recovery time, the method comprising:
receiving an input current signal at an input of a logarithmic transimpedance amplifier;
detecting a transition of the input current signal from a high current value to a low current value using a current pulse injection circuit; and
injecting a current pulse into the input of the logarithmic transimpedance amplifier in response to detecting the transition of the input current signal using the current pulse injection circuit.

10. The method of Claim 9, further comprising controlling at least one of an amplitude or a duration of the current pulse using a control signal,
and optionally further comprising generating the control signal using a non-volatile memory (NVM).

11. The method of Claim 9 or Claim 10, wherein a shape of the current pulse exponentially decays versus time.

12. The method of any of Claims 9 to 11, further comprising generating the input current signal using a photodiode.

13. The method of Claim 12, further comprising biasing a cathode of the photodiode with a bias voltage that is based on a current of the photodiode minus a threshold current value,
and optionally further comprising setting the threshold current value using a control signal.

14. A photocurrent detection system comprising:
a photodiode configured to generate an input current signal; and
a semiconductor die comprising a logarithmic transimpedance amplifier having an input configured to receive the input current signal, and a current pulse injection circuit configured to inject a current pulse into the input of the logarithmic transimpedance amplifier in response to detecting a transition of the input current signal from a high current value to a low current value.

15. The photocurrent detection system of Claim 15, wherein at least one of the following applies:
(a) at least one of an amplitude or a duration of the current pulse is set by a control signal;
(b) a shape of the current pulse exponentially decays versus time;
(c) the logarithmic transimpedance amplifier is configured to generate a copy of the input current signal that is provided to an input of the current pulse injection circuit.
